# EUROPEAN PATENT APPLICATION

(11) **EP 4 618 706 A1**
(43) Date of publication of application: **17.09.2025**
(21) Application number: 25162755.0
(22) Date of filing: 10.03.2025
(51) Int. Cl.: H05K 7/20

(54) **DATA CENTER THERMAL MANAGEMENT USING AISLE CONTAINMENT THERMOGRAPHIC CURTAINS**

(30) Priority: 11.03.2024 US 202463563872 P
(71) Applicant: ADP, Inc., Roseland, NJ 07068 (US)
(72) Inventor: GARCIA, Cosme, Roseland, 07068 (US)
(74) Representative: Morrall, Jonathan Ian McLachlan

(57) **Abstract**

The technical solution provides thermal management of data centers using containment curtains with thermographic material layers configured to change color in response to temperature changes. The solutions can identify, using video data, a layer of thermographic material applied on a portion of a material of a curtain disposed adjacent to a cabinet housing a plurality of computing devices configured to process requests and generate heat. The solutions can detect that a color of a portion of a layer of thermographic material is indicative of a temperature of a flow of air impacted by the heat. The solutions can determine, using the color and the location input into one or more machine learning (ML) models trained on the plurality of colors of a plurality of thermographic materials on a plurality of curtains adjacent to cabinets housing computing devices, that a computing device of the plurality of computing devices generates the heat that impacts the flow of air toward the portion of the layer. The solutions can load balance the requests across the plurality of computing devices responsive to the determination.

## Description

### CROSS-REFERENCES TO RELATED APPLICATIONS

This application claims the benefit of priority under 35 U.S.C. § 119 to U.S. Provisional Patent Application No. 63/563,872, filed March 11, 2024, which is hereby incorporated by reference herein in its entirety.

### TECHNICAL FIELD

The present disclosure relates generally to thermal management of data centers, and particularly to thermal management using airflow curtains with thermographic material layers including without limitation, systems and methods for data center thermal management using thermographic materials.

### BACKGROUND

Data centers can include computing devices, including servers, storage systems and networking devices (e.g., routers and switches), that can be stacked in housing cabinets. These housing cabinets can be arranged in rows forming aisles. During operation, computing devices can generate heat, which unless dissipated, can adversely affect the performance and longevity of the computing devices.

### SUMMARY

The technical solutions described herein provide thermal management of data centers using curtains with a thermographic material layer that can change color in response to temperature changes, facilitating identification of hot spots in the data centers. The curtains can be made with a transparent material, opaque material, or have any other level of translucency. As cabinets with computing devices can be arranged into aisles, distribution of heat generated by computing devices can impact the flow of air around the aisle, based on the device locations and heat generation as well as the aisle geometry. This can result in concentrated heated airflow (e.g., hotspots) formed in some locations within the aisle, which can cause some computing devices to be thermally impacted differently than others. While heat sensors and thermal imaging cameras can help identify the hotspots, such solutions can be complex and energy inefficient. The technical solutions of this disclosure overcome these challenges by providing airflow curtains formed from a thermographic material layer that can change color as the temperature of the curtain changes, thereby providing a continuous thermal distribution feedback. The technical solutions can utilize thermographic layers to monitor thermal distribution in and around the aisles to take corrective actions for improved thermal management, including using machine learning (ML) modeling to balance computing load across the computing devices, based on detected thermographic material hotspots.

An aspect of solutions can relate to a system. The system can include a plurality of cabinets. The system can include a plurality of computing devices housed within each cabinet of the plurality of cabinets to generate heat. The system can include one or more portions of transparent material to form a curtain adjacent to the plurality of cabinets to control a flow of air impacted by the heat. The system can include one or more layers of thermographic material applied on the one or more portions of transparent material to change a color of the one or more layers of the thermographic material responsive to a change in temperature caused by the flow of air.

An aspect of solutions can relate to a system. The system can include one or more processors coupled with memory and configured to identify, using one or more video frames captured by a camera, one or more layers of thermographic material. The one or more layers of thermographic material can be applied on one or more portions of a transparent material of a curtain. The curtain can be disposed adjacent to a plurality of cabinets housing a plurality of computing devices configured to process requests and generate heat. The one or more processors can be configured to detect that a color of a portion of a layer of the one or more layers of thermographic material is indicative of a temperature of a flow of air impacted by the heat. The one or more processors can be configured to determine, using the color and the location input into one or more machine learning (ML) models trained on the plurality of colors of a plurality of thermographic materials on a plurality of curtains adjacent cabinets housing computing devices, that a computing device of the plurality of computing devices generates the heat that impacts the flow of air toward the portion of the layer. The one or more processors can be configured to load balance requests across the plurality of computing devices responsive to the determination.

An aspect of solutions can relate to a non-transitory computer readable medium storing program instructions to cause at least one processor of a device to identify, using one or more video frames captured by a camera, one or more layers of thermographic material applied on one or more portions of a transparent material of a curtain. The curtain can be disposed adjacent to a plurality of cabinets housing a plurality of computing devices configured to process requests and generate heat. The instructions can cause the at least one processor to detect that a color of a portion of a layer of the one or more layers of thermographic material is indicative of a temperature of a flow of air impacted by the heat. The instructions can cause the at least one processor to determine, using the color and the location input into one or more machine learning (ML) models trained on the plurality of colors of a plurality of thermographic materials on a plurality of curtains adjacent cabinets housing computing devices, that a computing device of the plurality of computing devices generates the heat that impacts the flow of air toward the portion of the layer. The instructions can cause the at least one processor to load balance requests across the plurality of computing devices responsive to the determination.

An aspect of solutions can relate to a method. The method can include identifying, by one or more processors coupled with memory, using one or more video frames captured by a camera, one or more layers of thermographic material applied on one or more portions of a transparent material of a curtain. The curtain can be disposed adjacent to a plurality of cabinets housing a plurality of computing devices processing requests and generating heat. The method can include detecting, by the one or more processors, that a color of a portion of a layer of the one or more layers of thermographic material is indicative of a temperature of a flow of air impacted by the heat. The method can include determining, by the one or more processors, using the color and the location input into one or more machine learning (ML) models trained on the plurality of colors of a plurality of thermographic materials on a plurality of curtains adjacent cabinets housing computing devices, that a computing device of the plurality of computing devices generates the heat that impacts the flow of air toward the portion of the layer. The method can include load balancing, by the one or more processors, the requests across the plurality of computing devices responsive to the determination.

An aspect of solutions can relate to a method. The method can include one or more processors coupled with memory identifying a plurality of cabinets. The method can include the one or more processors identifying a plurality of computing devices housed within each cabinet of the plurality of cabinets to generate heat. The method can include detecting, by the one or more processors, one or more portions of transparent material to form a curtain adjacent to the plurality of cabinets to control a flow of air impacted by the heat. The method can include detecting, by the one or more processors, one or more layers of thermographic material applied on the one or more portions of transparent material to change a color of the one or more layers of the thermographic material responsive to a change in temperature caused by the flow of air.

An aspect of solutions can relate to an apparatus. The apparatus can include a curtain that extends along at least a portion of an array of cabinets that house a plurality of computing devices in a data center. The curtain can include an opening to receive heat dissipated from the plurality of computing devices at the at least the portion of the array. The curtain can include a thermographic material configured to change color to indicate an amount of the heat dissipated by the plurality of computing devices located at the at least the portion of the array.

### BRIEF DESCRIPTION OF THE DRAWINGS

Aspects of the present disclosure are described in the detailed description which follows, in reference to the noted plurality of drawings by way of non-limiting examples of exemplary embodiments of the present disclosure.
FIG. 1 is an illustrative example of a material strip having thermographic layers that can be used for temperature detection in a curtain of a data room aisle.
FIG. 2 illustrates another example of a material strip having thermographic layers arranged in various shapes, such as strips or a grid, to be used for temperature detection in a curtain of a data room aisle.
FIG. 3 illustrates an example of a data room having cabinets housing computing devices for processing data.
FIG. 4 illustrates an example of a data room having cabinets and curtains with thermographic layers.
FIG. 5 illustrates an example of a data room having hot and cold aisles separated by cabinets and curtains with thermographic layers showing hotspot locations.
FIG. 6 illustrates an example block diagram of a system for load balancing of computing devices using curtains with thermographic layers and machine learning.
FIG. 7 illustrates an example block diagram of a computing system that can be used for implementing the technical solutions of the present disclosure, including in computing devices or data processing systems.
FIG. 8 shows an example process flow of method for providing thermal management solutions using data room curtains with thermographic layers.

### DETAILED DESCRIPTION

The technical solutions described herein provide systems and methods for thermal management of data centers using curtains having thermographic material that is configured to change color in response to temperature changes. Data rooms that include cabinets storing computing devices (e.g., servers processing network traffic requests) can experience elevated temperatures due to heat generated by the devices. Airflow generated by these devices can produce hotspots, which can include localized areas in which temperatures are higher than that of surrounding areas. These hotspots can be indicative of various issues in the data room, including faulty or overheated computing devices due to overuse, or particular manner of use.

However, pinpointing or otherwise identifying or locating the hotspots can be challenging. Containment curtains that can be used to control the airflow in the data room (e.g., to separate the air from hot and cold aisles) lack the ability to pinpoint the sources of heat within enclosed spaces. While thermal sensors can be deployed to help understand the heat distribution in the data room, such systems are complex, costly, and energy inefficient. The solutions presented in this disclosure address these challenges by providing airflow curtains made of transparent materials embedded with thermographic layers capable of real-time color-changing, thereby providing a constant and energy-efficient real-time feedback of temperature fluctuations. The current solutions can use thermographic layers to monitor thermal distribution in and around aisles, facilitating corrective measures for enhanced thermal management, including identification of overheated computing devices or suggesting corrective measures to the airflow to eliminate or reduce the hotspots in the data room. Additionally, machine learning (ML) modeling can be utilized to provide solutions, based on the thermographic layer readings, including computing device load balancing based on identified hotspots detected by the thermographic materials. In some examples, the thermographic layer readings can be used as input to systems that adjust the airflow based on such input.

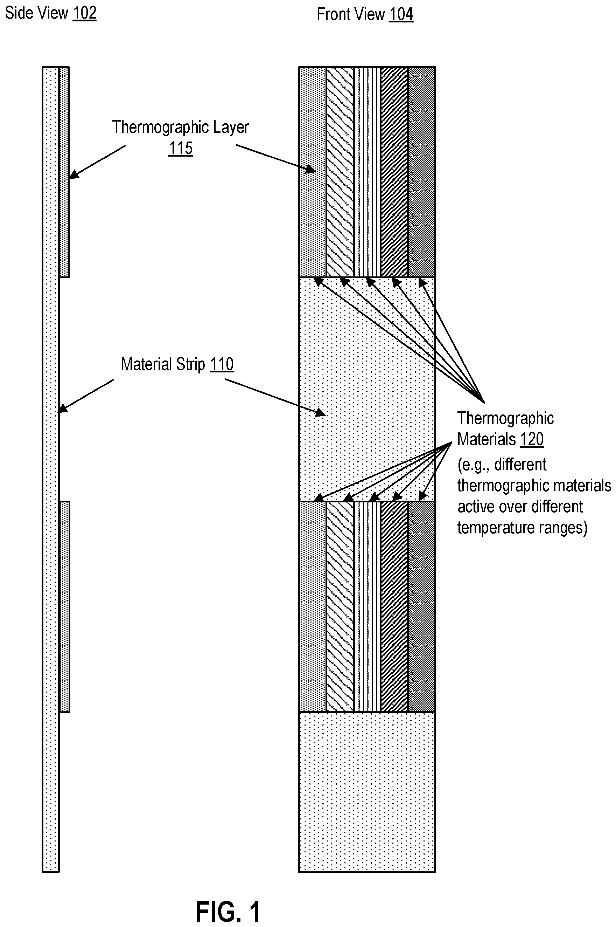

FIG. 1 illustrates an example 100 of a material strip 110 having thermographic layers 115 that can be used for temperature detection in a curtain of a data room aisle. Example 100 provides a side view 102 of a cross-section of a material strip 110 with a thermographic layer 115 applied thereon. Example 100 also provides a front view 104 of a same or a different material strip 110 having one or more thermographic layers 115, which can include a plurality of different thermographic materials 120.

Material strip 110 can include any type, form, shape or size of material that can be used as a curtain controlling airflow between different regions of a data room. Material strip 110 can include a partially or fully transparent or translucent material, such as a sheet of clear or partially clear plastic or polymer. Material strip 110 can include any material, such as a polyvinyl chloride (PVC), nylon, or other transparent or partially transparent materials, including vinyl, polyester, polyurethane, rubber, silicone, acrylic, polyurethane terephthalate (Mylar) or polypropylene. Material strips 110 can be used as, or be combined with other material strips 110, to form curtains between these areas. Material strips 110 can act as airflow barriers, allowing for the division of space into distinct zones while maintaining visibility and accessibility. For instance, one or more material strips 110 can include PVC or nylon materials and can provide an effective thermal barrier between the hot and cool aisles housing rows of server cabinets. Material strips 110 can provide both visibility and insulation, allowing for visual monitoring of the server cabinets, aisles or hotspots, while also providing adequate thermal separation.

Thermographic material 120 can include any material or a substance that changes color or appearance in response to a temperature change. Thermographic material 120 can include a material that opaque or at least partially translucent or transparent at one temperature and opaque or less transparent or translucent at another temperature. The material can be translucent or transparent by any percentage of light throughput, such as up to 5%, 10%, 20%, 40%, 60%, 70%, 90%, 95% or more than 95%. Thermographic material 120 can include a material that is transparent or translucent at one temperature and exhibits a color (e.g., red or black) when subjected to another temperature range. Thermographic material 120 can include any thermographic materials, such as liquid crystal mixtures, or thermochromic inks and paints. Thermographic material 120 can adjust its color, texture, hue or opacity based on temperature variations. In doing so, when applied to temperature variations, thermographic material 120 can be used to identify temperature changes with particular temperature range. Thermographic material 120 can include one or more polymers and plastics that can include inherent thermochromic properties, such as altering color or transparency as temperatures shift. Thermographic material 120 can include thermochromic pigments, microencapsulated materials, and alloys, which can provide different temperature-sensitive reactions. Thermographic material 120 can be configured to change its color in response to experiencing a temperature over a specific temperature range, such as for example, any temperature range between 30-100F, such as 60-70F, 70-80F or 80-90F.

Thermographic layer 115 can include any layer of one or more thermographic materials 120. Thermographic layer 115 can include a layer of material deposited, painted, sprayed, coated or otherwise applied on top of a material strip 110 material (e.g., nylon or PVC used a thermal curtain in a data room). Thermographic layer 115 can include thermographic materials 120 inserted, doped or implanted into material strips 110. Thermographic layers 115 can include multiple layers of one or more same or different types of materials.

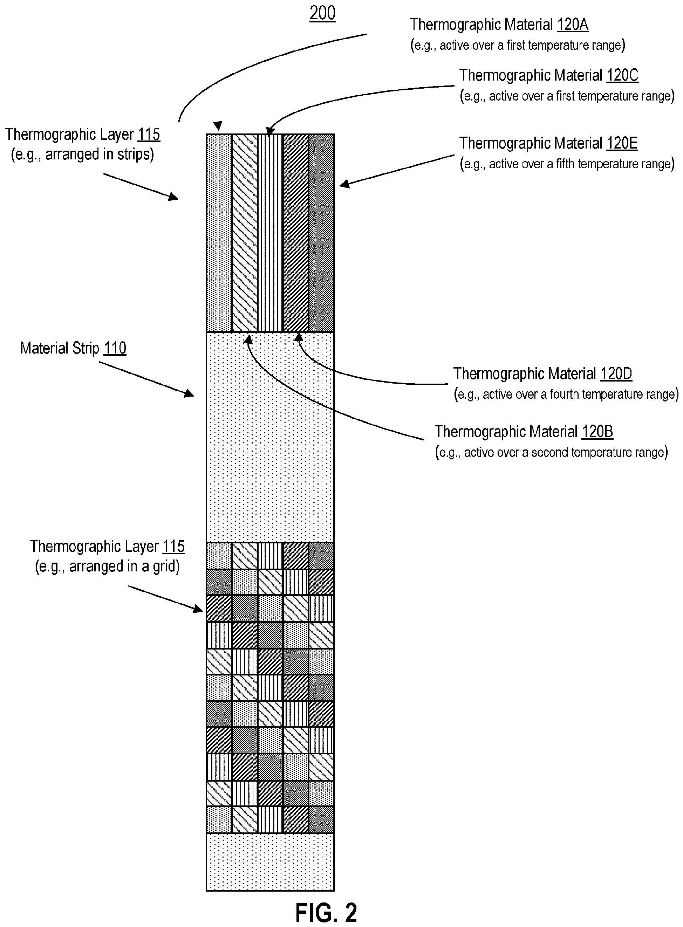

FIG. 2 illustrates an example 200 of a material strip 110 having various types of thermographic materials 120 applied as one or more thermographic layers 115 and arranged in various shapes (e.g., as strips or a tile grid) on top of a material strip 110. Various thermographic materials 120A-E can be configured to cover, or be responsive to, different temperature ranges and can be used for temperature detection in a curtain of a data room aisle to cover a broad range of temperature.

As shown in the top portion of FIG. 2, thermographic layer 115 can include an arrangement in which elongate strips of thermographic materials 120A, 120B, 120C, 120D and 120E can be applied along the material strip 110. Thermographic materials 120A-E can be applied next to each other, thereby covering at least a portion of the material strip 110. As shown, for example, in the bottom portion of FIG. 2, a thermographic layer 115 can include an arrangement in which square-shaped portions of different thermographic materials 120A-E are arranged as a grid or tiled across the surface of the material strip 110.

While several arrangements and/or configurations of the thermographic layer 115 are depicted in the accompanying figures, it is understood that several other combinations are possible and covered by the present application. In some examples, the arrangement of the thermographic materials 120A-E can use different shapes from those depicted; for example, triangles, circles, rectangles, polygons, curved strips, or any other shape may be used. Further, in some examples, the thermographic materials may be arranged on the inside of the material strip 110. Alternatively, in some examples, a subset of the thermographic materials, say 120A-C, is on the inside, and the remaining thermographic materials, in this case 120D-E, are on the outside of the material strip 110. Several other combinations are possible.

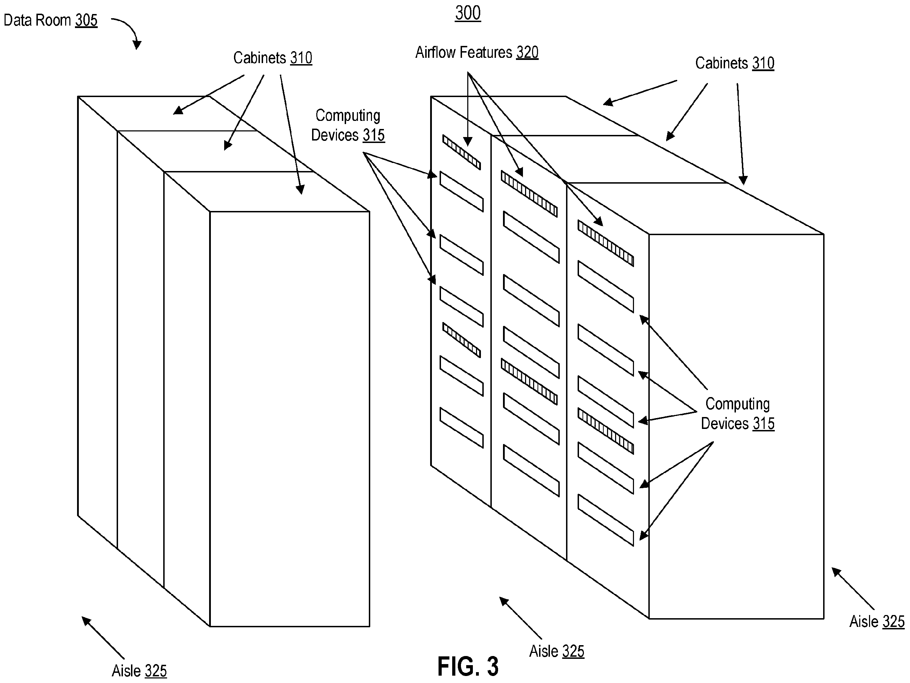

FIG. 3 illustrates an example 300 of a data room 305 including a plurality of cabinets 310 for housing computing devices 315 configured for processing data (e.g., network traffic of a data center). Example 300 shows a data room having a plurality of cabinets 310 arranged or stacked in rows to form aisles 325. Cabinets can include computing devices 315 which can face the same side, such that some of the aisles 325 have all the computing devices 315 from the cabinets 310 from either side facing the aisle 325 (e.g., a hot aisle). Cabinets can include computing devices 315 facing away from the aisle 325, such that all computing devices 315 are not facing towards a particular aisle 325 (e.g., a cold aisle).

Data room 305 can include any room, area or a facility for housing and operating computing resources and data infrastructure. Data room 305 can include a location in which servers, network switches, or other computing resources of an enterprise (e.g., a company or an organization) are housed for operation. Data room 305 can include an area configured to provide suitable conditions for the storage, processing, and management of digital information, including sensitive and proprietary data. Data room 305 can include specialized equipment such as server racks, network cabinets, and cooling systems (e.g., air conditioning systems) to support the operation of the computing devices 315 (e.g., servers, switches, routers, and storage devices).

Cabinets 310 can include any enclosure or structure designed or dedicated for storing or housing computing devices for data management and processing. Cabinets 310 can be configured to provide physical protection, organization, and efficient management of computing devices, such as servers, computers, switches, routers, power supplies, or other devices for supporting or providing data infrastructure. Cabinets 310 can include server racks that can include metal frames with adjustable shelves or rails to accommodate different types and sizes of equipment. Cabinets can include enclosures configured for organizing networking devices such as switches and routers, including cable management solutions and ventilation systems (e.g., fans or convection cooling slits) to provide improved airflow and cooling.

Computing devices 315 can include any type or form of an electrical, electronic or computing device for a data processing infrastructure. Computing device 315 can include any device or a system serving various functions in data processing, storage, and networking. For example, computing devices 315 can include servers, including computers designed to handle large volumes of data processing tasks. Computing devices 315 can include rack-mounted servers, blade servers, or tower servers, each offering specific advantages in terms of scalability, density, and performance. Computing devices 315 can include switches and routers to facilitate data communication and connectivity within a data center. Computing devices 315 can include storage devices, such as NAS (Network Attached Storage) or SAN (Storage Area Network) devices, which can be housed in cabinets to provide centralized data storage and retrieval capabilities.

Airflow features 320 on cabinets 310 can include any device, system, feature, structure or a component that can facilitate, adjust, impact or otherwise manage airflow within, from, to, or around any computing devices 315, cabinets 310, aisles 325 or data rooms 305. Airflow features 320 can include components, features or devices designed or configured to direct, redirect, distribute, or modify airflow to adjust airflow or heat distribution and improve cooling efficiency. Airflow features 320 can include slits, holes or through-holes for facilitating airflow, perforated doors allowing air ingress and egress, brush grommets sealing cable entry points while allowing airflow, blanking panels preventing or controlling air recirculation, internal baffles or fins directing airflow along specific paths, and hot aisle/cold aisle containment systems separating hot and cold air streams. Airflow features 320 can include active cooling components, such as fans, cold plates, air conditioning units, precision air conditioners, chilled water systems, liquid cooling systems, cold aisle and hot aisle containment systems (e.g., curtains), in-row cooling units or heat exchangers. Airflow features 320 can include variable speed fans for adaptive cooling, as well as rack-level cooling systems providing targeted airflow to computing devices. Airflow features 320 can be controlled by a data processing system, which can include controllers for adjusting, operating or managing airflow features 320 to make adjustments to airflow or heat distribution (e.g., attenuation or removal of hotspots) in a data room 305.

An aisle 325 can include any space, corridor or passageway created between adjacent rows of cabinets 310. Aisle 325 can include a space between two or more cabinets 310 to provide access for maintenance, equipment installation, and airflow management. Aisles 325 can be used for operation and organization within the data room 305, facilitating ease of movement, accessibility to computing devices 315 and airflow control. Aisles 325 can be configured as hot or cold aisles, depending on the intended purpose in airflow management. For example, an aisle 325 can be configured as a hot aisle to contain heated exhaust airflow from the computing devices 315 generating heat. For example, an aisle 325 can be configured as a cold aisle 325 to contain or supply cool air to the front intake of the computing devices 315, thereby cooling the computing devices.

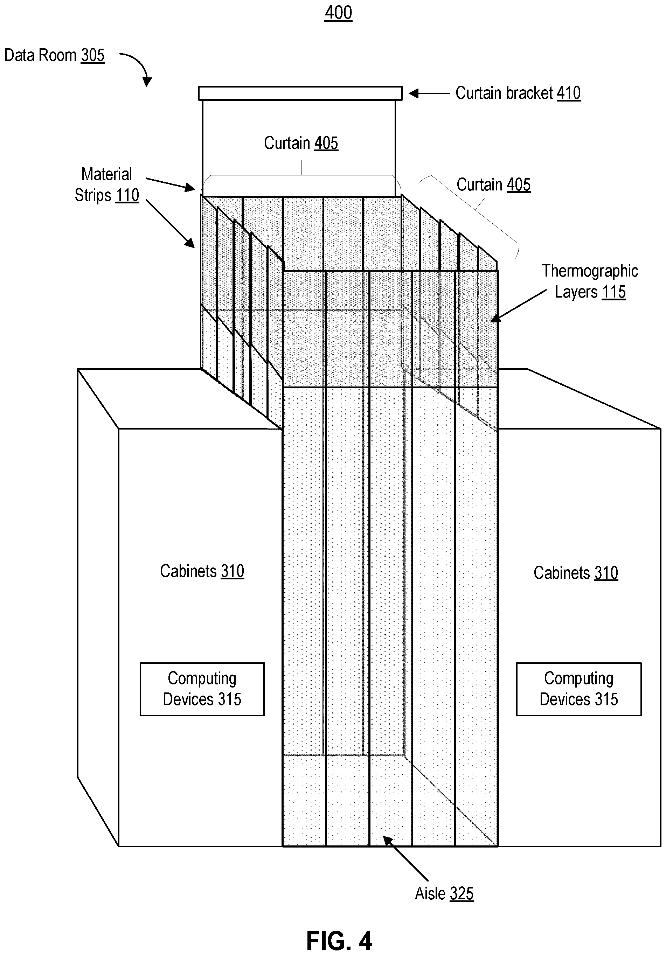

FIG. 4 illustrates an example 400 of a data room 305 having cabinets 310 whose airflow is contained by containment curtains 405 formed using material strips 110 with thermographic layers 115. Example 400 includes two adjacent or parallel rows of cabinets 310 forming an aisle 325. Aisle 325 can have its airflow contained using the cabinets 310 blocking the airflow on the sides of the aisle and curtains 405 covering the two ends of the aisle 325. Curtains 405 can also be disposed on top of the cabinets 310 to cover the sides of the aisle 325 above the cabinet level. Curtain brackets 410 can be used to suspend the curtains 405 (e.g., material strips 110) from a ceiling of a data room 305 and provide mechanical support for the curtains 405.

Curtain 405 can include any barrier for controlling, containing or directing airflow and separating different temperature zones within the data room 305. Curtain 405 can include any flexible material acting as a flexible barrier for an area within the data room 305. Curtain 405 can be formed by material strips 110 and can facilitate the regulation and direction of air movement within a defined space. Curtains 405 can serve to partition areas, such as between hot and cold aisles 325 in a data room 305, to improve airflow management and temperature distribution. Material strips 110 can be used in these curtains 405 and can include thermographic material 115 that can change color in response to temperature changes and provide visual cues for monitoring airflow patterns and identifying hotspots or other areas of concern.

Curtain bracket 410 can include any component, device, structure or a system for suspending, holding or providing mechanical support for the curtain 405 or material strips 110. Bracket 410 can include one or more brackets or structures that can be mounted on a ceiling of a data room 305, along with strings tied to the curtain 405 to hold the curtain in place (e.g., at a particular height and over a particular area).

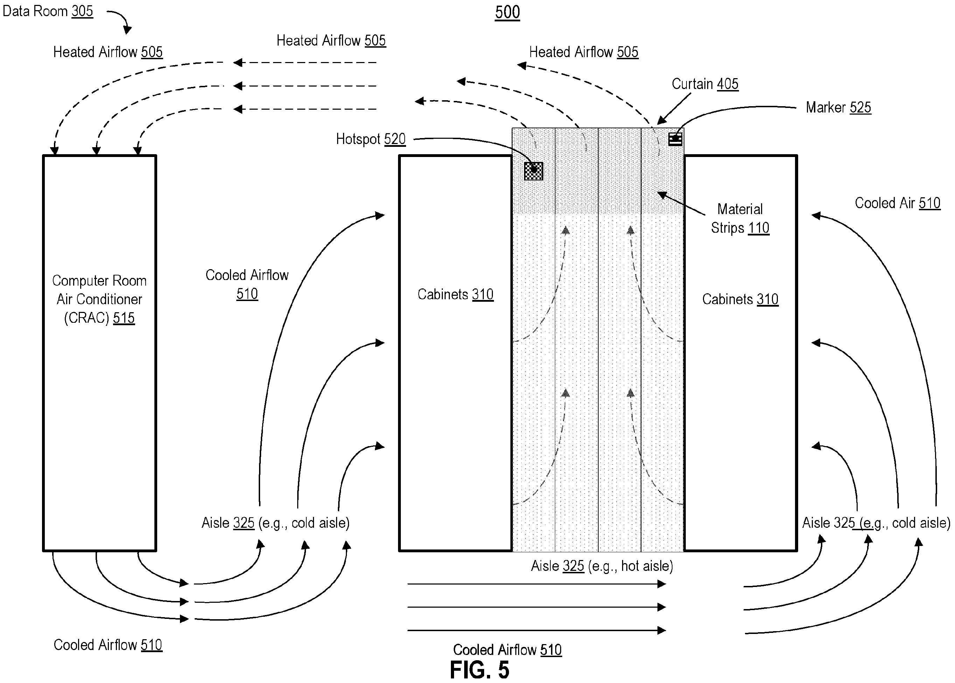

FIG. 5 illustrates an example 500 of a data room 305 having hot and cold aisles 325 separated by cabinets 310 and curtains 405 that can show locations of hotspots 520 using thermographic layers 115. Example 500 can include a data room 305 having adjacent rows of cabinets 310 forming aisles 325. Some of the aisles 325 can be configured as hot aisles for cycling or routing the heated airflow 505 from the computing devices 315 in the cabinets 310. Some of the aisles 325 can be configured as cold aisles for cycling or routing the cooled airflow 510 from the computer room air conditioner (CRAC) 515.

For example, heated air can exit from the computing devices 315 in the cabinets 310 and flow into the hot aisle 325 that can be contained using curtains 405 formed using interconnected material strips 110. The material strips 110 can be connected to each other using magnets at the edges of the material strips 110, which can facilitate sealing of the curtain 405. Material strips 110 can include thermographic layers 115 that can include markers 525 for identifying locations of hotspots 520. The technical solutions can include a data processing system that can utilize video frames from cameras to identify locations of hotspots 520 on the thermographic layers 115 based on the locations of one or more markers 525.

Computer room air conditioner (CRAC) 515 can include any cooling system that can be used to regulate the temperature or humidity levels within a data room 305. CRAC 515 can receive heated airflow 505 that can include heated air currents from convective heat dissipated from the computing devices 315 housed in cabinets within the data room 305. CRAC 515 can include and utilize refrigeration and air circulation functionalities to cool the incoming heated airflow 505 to create cooled airflow 510. CRAC 515 can redistributing the cooled airflow 510 back into the room, using curtains 405 or geometries of the data room 305 (e.g., ducts, pipes, linings or room features) to provide the cooled airflow 510 to the computing devices 315 within the cabinets 310. CRAC 515 can include components such as compressors, condensers, evaporators, and fans to facilitate the air-cooling process. CRAC 515 can be managed and controlled by the data processing system to facilitate timely and controlled airflow and cooling to facilitate the reliable operation and performance within the data room 305.

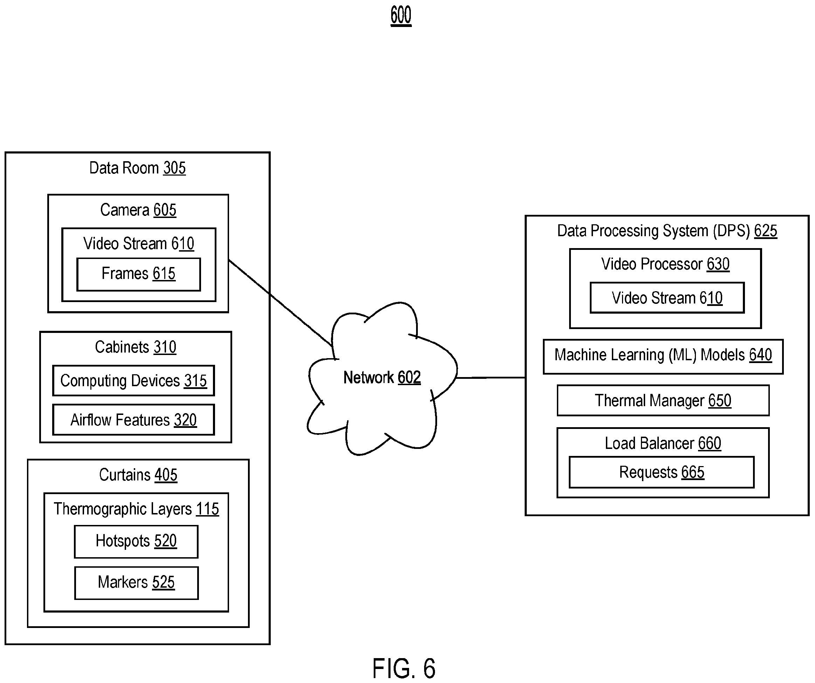

FIG. 6 illustrates an example block diagram of a system 600 for load balancing of computing devices 315 using curtains with thermographic layers 115 and machine learning. Example system 600 can include a data room 305 having one or more cameras 605 for capturing video streams 610 of a plurality of video frames 615. Camera 605 can capture frames 615 any portion of the data room 305, including cabinets 310 having computing devices 315, curtains 405 having thermographic layers 115 identifying hotspots 520 based on locations of markers 525. Across a network 602, a data processing system (DPS) 625 can receive the video stream from the camera 605 and process it with a video processor 630. DPS 625 can include one or more machine learning (ML) models 640 for processing video stream 610 to identify the locations of the hotspots 520 and determine corrective action to take to reduce the hotspots 520. The corrective action can include using a load balancer 660 to adjust load balancing of the network requests 665 processed by the computing devices 315 so as to address, reduce or eliminate the hotspot 520. The corrective action can include using a thermal manager 650 to correct airflow features 320 and adjust the heated airflow 505 or cooled airflow 510 in the data room 305.

Camera 605 can include any combination of hardware and software for capturing images of a data room 305. Camera 605 can include a hardware device, such as an image capture device, to capture visual data, including digital images or digital videos. Camera 605 can include a digital camera, an infrared or a thermal camera, a surveillance camera, a webcam, a digital single lens reflex camera or any other type or form of a camera device. Camera 605 can capture images or videos in the forms of video streams 610 of any number of video frames 615. Camera 605 can include optical components for image capture and electronic components for signal processing and transmitting the captured data to a data processing system 625 for further analysis and processing.

Video stream 610 can include any continuous flow of visual data, such as images or video frames, that can be captured by camera 605. Video stream 610 can include data captured and transmitted in real-time and can be used for continuous surveillance or monitoring of an area, such as a data room 305. Video stream 610 can include a sequence of frames 615 that can represent or include individual snapshots or images of a visual scene (e.g., data room 305) captured by the camera 605. Video stream 610 can include a live feed from a surveillance cameras 605 monitoring server racks or equipment cabinets 310 for temperature fluctuations or airflow issues, as exhibited or reflected in the thermographic layers 115.

A frame 615 can include any individual or still image of a video stream 610 captured and transmitted by a camera 605. Frame 615 can include an image of a sequence of 1, 5, 10, 15, 30, 60, 90, 120 images captured by camera 605 per second. Each frame 615 can include visual information representing a specific moment in time within the data room 305, such as a snapshot of a data room. Each frame 615 can include or represent a state or position of a curtain 405, any changes to color in the thermographic layers 115, any hotspots 520 or markers 525, which can be used by the DPS 625 to determine airflow movement or corrective action to take. Frames 615 can include still images of server racks or cabinets 310, computing devices 315 (e.g., servers) or airflow patterns as reflected in the thermographic materials 120 on the curtains 405, as captured by surveillance cameras 605 in the data room 305.

Data processing system (DPS) 625 can include any combination of hardware and software for monitoring temperature of a data room 305 using curtains 405 having transparent material strips 110 with thermographic layers 115 exhibiting hotspots 520. DPS 625 can include any computer code, functions and data processed or executed on one or more servers, virtual machines, Software as a Service (SaaS), cloud-based systems or any other computing environment. DPS 625 can receive, parse and process video stream 610 and identify video frames 615. DPS 625 can detect distinct features within the frames 615, including curtains 405, material strips 110, thermographic layers 115, markers 525 and hotspots 520.

Data processing system 625 can include a computational framework configured to analyze and process video streams 610 captured by camera 605 to identify airflow movements, hotspots 520 or corrective actions to take. DPS 625 can include, or be implemented by, computing systems, such as servers, processors, and storage systems, as well as software components for data analysis, machine learning, and decision-making.

Video processor 630 can include any combination of hardware and software for processing videos streams 610. Video processor 630 can include the functionality for analyzing and processing video streams 610, frames 615 and identifying their features. Video processor 630 can include hardware or software algorithms for utilizing ML models 640 to extract relevant data from the video stream 610, such as detecting anomalies or identifying patterns, airflow movements or hotspots 520 on the curtains 405.

Machine learning (ML) models 640 can include any computational algorithms that can learn patterns and relationships from data to make predictions or decisions relating color changing of thermographic layers 115, hotspots 520 and the related airflow movement. ML models 640 can be trained to determine sources of increased heat, reasons for particular hotspot 520 formation or corrective actions to take to alleviate or reduce the hotspots 520. ML models 640 can be trained using datasets on computational fluid dynamics (CFD) analysis for airflow in a data room. ML models 640 can be trained on historical data to recognize patterns and anomalies the airflow movement based on the features captured in the video streams 610, such as hotspots 520 with respect to markers 525. For instance, ML model 640 can identify a formation of a hotspot 520, based on a thermographic layer 115 changing color (e.g., to form the hotspot 520). ML model 640 can determine, based on the location of the hotspot, a cause of the hotspot, such as a faulty computing device 315, an overheated or overburdened computing device 315, a blocked or malfunctioning airflow feature 320, or a change or adjustment to make to the CRAC 515 or an airflow feature 320 to address or change the speed or direction of the airflow (e.g., 505 or 510).

ML models 640 can include and utilize any ML architecture, such as transformer architecture, convolutional neural network (CNN) architecture or a graph neural network (GNN) architecture, for processing video streams and identifying airflow patterns and causes of hotspots. For example, ML models 640 can include neural networks trained to detect temperature fluctuations or airflow disruptions in surveillance videos within the data room. For instance, ML models 640 can include CNN ML model to extract features from visual data and identify anomalies or hotspots. For example, ML models 640 can include GNN architecture to model relationships between different components in data room 305, such as CRAC 515, cabinets 310, aisle 325, curtains 405 and discern airflow pathways.

Thermal manager 650 is a component of the data processing system 625 responsible for monitoring and managing thermal conditions within the data room. It receives input from ML models 640 analyzing video streams 610 and makes adjustments to airflow systems or cooling infrastructure to maintain optimal thermal conditions for equipment operation. Examples of thermal managers include automated HVAC systems or intelligent control systems that adjust fan speeds or airflow patterns based on ML model predictions.

Load balancer 660 can include any combination of hardware and software for distributing incoming requests 665 among multiple computing devices 315. Load balancer 660 can include the functionality to distribute the requests 665 across the computing devices 315 to improve or optimize the performance and resource utilization. Load balancer 660 can even out computational tasks related to network traffic processing performed by the computing devices 315. Load balancer 660 can utilize video processing and ML models 640 to determine from determined or inferred air movements, which of the computing devices are to have their network traffic increased and which one are to have their network traffic reduced.

Requests 665 can include any incoming requests, data or processing tasks directed to the computing devices 315 of the data room 305. Requests 665 can include any type and form of requests serviced by computing devices, such as hypertext transfer protocol (HTTP) requests, HTTP secure (HTTPS) requests , file transfer protocol (FTP) requests, domain name system (DNS) requests, simple mail transfer protocol (SMTP) requests, secure shell (SSH) requests, structured query language (SQL) requests, application programming interface (API) call or any other type and form of requests in the network traffic that computing devices can service. Requests 665 an include requests for real-time video analysis, inference of ML models, or adjustments to thermal management systems based on detected anomalies in video streams 610.

Network 602 can include one or more types of networks that can be used for communication between a camera 605 and a DPS 625. Network 602 can include one or more Local Area Networks (LANs), which can be used within a limited geographical area, such as an office or building, and Wide Area Networks (WANs), which span larger distances and can connect devices across cities or countries. Network 602 can include one or more Metropolitan Area Networks (MANs) which can be utilized to cover a city or metropolitan area. Network 602 can support internet-based connections, using protocols like TCP/IP, and enable access to cloud-based data processing systems. Network 602 can include or support wireless networks, such as Wi-Fi and cellular networks, as well as Virtual Private Networks (VPNs) which can provide security to public networks. Network 602 can include or utilize Intranets (e.g., private networks within an organization) facilitating internal communications.

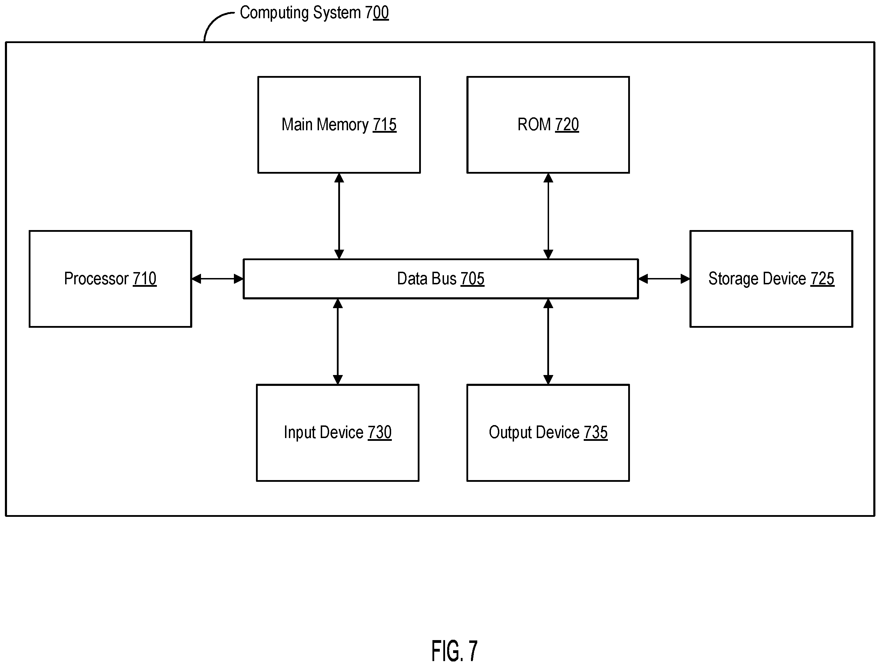

FIG. 7 illustrates a block diagram of a computing system 700 for implementing the embodiments of the present solution, in accordance with embodiments. FIG. 7 illustrates a block diagram of an example computing system 700, which can also be referred to as the computer system 700. Computing system 700 can be used to implement elements of the systems and methods described and illustrated herein, such as for example, commands, instructions or data described herein. Computing system 700 can be included in and run any device (e.g., DPS 625, ML models 640, or any other feature or component of example systems 100-600).

Computing system 700 can include at least one bus data bus 705 or other communication device, structure or component for communicating information or data. Computing system 700 can include at least one processor 710 or processing circuit coupled to the data bus 705 for executing instructions or processing data or information. Computing system 700 can include one or more processors 710 or processing circuits coupled to the data bus 705 for exchanging or processing data or information along with other computing systems 700. Computing system 700 can include one or more main memories 715, such as a random-access memory (RAM), dynamic RAM (DRAM), cache memory or other dynamic storage device, which can be coupled to the data bus 705 for storing information, data and instructions to be executed by the processor(s) 710. Main memory 715 can be used for storing information (e.g., data, computer code, commands or instructions) during execution of instructions by the processor(s) 710.

Computing system 700 can include one or more read only memories (ROMs) 720 or other static storage device 725 coupled to the bus 705 for storing static information and instructions for the processor(s) 710. Storage devices 725 can include any storage device, such as a solid-state device, magnetic disk or optical disk, which can be coupled to the data bus 705 to persistently store information and instructions.

Computing system 700 may be coupled via the data bus 705 to one or more output devices 735, such as speakers or displays (e.g., liquid crystal display or active-matrix display) for displaying or providing information to a user. Input devices 730, such as keyboards, touch screens or voice interfaces, can be coupled to the data bus 705 for communicating information and commands to the processor(s) 710. Input device 730 can include, for example, a touch screen display (e.g., output device 735). Input device 730 can include a cursor control, such as a mouse, a trackball, or cursor direction keys, for communicating direction information and command selections to the processor(s) 710 for controlling cursor movement on a display.

The processes, systems and methods described herein can be implemented by the computing system 700 in response to the processor 710 executing an arrangement of instructions contained in main memory 715. Such instructions can be read into main memory 715 from another computer-readable medium, such as the storage device 725. Execution of the arrangement of instructions contained in main memory 715 causes the computing system 700 to perform the illustrative processes described herein, such as actions or functions of the DPS 625. One or more processors 710 in a multi-processing arrangement may also be employed to execute the instructions contained in main memory 715. Hard-wired circuitry can be used in place of or in combination with software instructions together with the systems and methods described herein. Systems and methods described herein are not limited to any specific combination of hardware circuitry and software.

Although an example computing system has been described in FIG. 7, the subject matter including the operations described in this specification can be implemented in other types of digital electronic circuitry, or in computer software, firmware, or hardware, including the structures disclosed in this specification and their structural equivalents, or in combinations of one or more of them.

In one aspect, the technical solutions can be directed to a system, such as a system including features or components shown in examples 100-600. The system can include a data room 305 having a plurality of cabinets 310 and a plurality of computing devices 315 housed within each cabinet 310 of the plurality of cabinets 310. Computing devices 315 can be configured to operate or process network traffic and generate heat upon such processing or operation. The processing of network traffic or data can include processing of network requests 665. The system can include one or more portions of transparent material to form a curtain 405 adjacent to the plurality of cabinets 310 to control a flow of air (e.g., 505, 510) impacted by the heat. The curtain 405 can be formed by connecting or suspending side-by-side of the plurality of material strips 110. The system can include one or more layers of thermographic material (e.g., 115) applied on the one or more portions of transparent material 110 to change a color of the one or more layers of the thermographic material (e.g., 115) responsive to a change in temperature caused by the flow of air (e.g., 505, 510).

The one or more portions of transparent material 110 includes a plurality of strips of a polymer material, vinyl or nylon material. The polymer, vinyl or nylon material can be at least partially transparent to light in a visible spectral range (e.g., 380-700nm wavelength). The plurality of strips 110 can include at least two strips of the plurality of strips suspended vertically (e.g., from a bracket 410) and at least partly overlapping side by side with each other to form the curtain 405. The one or more layers of thermographic material (e.g., 115) can include a layer of a plurality of thermographic materials (e.g., 120A-E). Each thermographic material (e.g., 120) of the plurality of thermographic materials (e.g., 120) can correspond to a separate portion of the layer 115.

The one or more layers of thermographic material 115 can include a plurality of layers of the thermographic materials 115. The plurality of layers 115 can be applied one on top of another. Each layer of the plurality of layers of the thermographic materials (e.g., 115) can include a thermographic material 120 configured to change color responsive to experiencing temperature within a predetermined temperature range. The temperature ranges for various thermographic materials 120 can vary, such as that each of the thermographic materials 120 reacts to changes in temperatures within a different temperature range than other thermographic materials 120.

The one or more layers of thermographic material 115 can include a plurality of portions of a layer 115 covering a plurality of portions of a surface of the transparent material 110. Each of the portions of the layer 115 can include a different thermographic material 120 of a plurality of thermographic materials 120. A layer 115 of the one or more layers of the thermographic material (e.g., 115) can include a first portion of the layer 115 covering a first portion of the transparent material 110 and including a first thermographic material 120 configured to change color responsive to a change in temperature over a first temperature range. The layer 115 can include a second portion of the layer 115 covering a second portion of the transparent material 110 and including a second thermographic material 120 configured to change color responsive to a change in temperature over a second temperature range different than the first temperature range.

The system can include an aisle 325 formed by the plurality of cabinets 310. The system can include a bracket 410 to suspend the curtain 405 adjacent to the aisle 325 to control the flow of air (e.g., 505 or 510) within the aisle 325 impacted by the heat generated by the plurality of cabinets 310. Each computing device of the plurality of computing devices 310 can include one or more integrated circuits (e.g., processors 710) to process data responsive to requests 665 and generate the heat to impact the flow of air (e.g., 505, 510) in the aisle 325 responsive to the processing of data.

The system can include one or more features 320 of the plurality of cabinets 310 to control the flow of air (e.g., 505, 510) within the aisle. The one or more features 320 can be adjustable responsive to a change in the color of the one or more layers of the thermographic material. The system can include the plurality of cabinets 310 including a first plurality of cabinets 310 on a first side of the aisle 325 and a second plurality of cabinets 310 on a second side of the aisle 325. The aisle 325 can be parallel to a second aisle 325 formed by the second plurality of cabinets 310 and a third plurality of cabinets 310 comprising one or more computing devices 315 of the plurality of computing devices 315. The curtain 405 can form a barrier surrounding the aisle 325 to preclude the flow of air (e.g., airflows 505, 510) along at least a length of the aisle 325 and a width of the aisle 325.

An aspect of the technical solutions can be directed to a system, such as a system including characteristics of examples 100-700. The system can include one or more processors 710 coupled with memory (e.g., 715, 720, 725) and configured to implement functionality of a DPS 625. The one or more processors 710 can be configured to implement the functionalities of the technical solutions by storing instructions, commands or computer code configured or designed to perform the tasks of the technical solutions using the one or more processors 710.

The one or more processors 710 can be configured to identify, using one or more video frames 615 of a video stream 610 captured by a camera 605, one or more layers of thermographic material 115. The one or more layers (e.g., 115) of thermographic material 120 can be applied on one or more portions of a transparent material 110 of a curtain 405. The curtain 405 can be disposed adjacent to a plurality of cabinets 310 housing a plurality of computing devices 315 configured to process requests and generate heat. The one or more processors 710 can be configured to detect that a color of a portion of a layer 115 of the one or more layers of thermographic material (e.g., 115) is indicative of a temperature of a flow of air (e.g., 505, 510) impacted by the heat.

The one or more processors 710 can train, identify and retrieve one or more machine learning (ML) models 640 that can be trained on the plurality of colors of a plurality of thermographic materials 120 on a plurality of curtains 405 adjacent cabinets 310 housing computing devices 315. The one or more ML models 640 can be trained using various sources of heat and various housing structures arranged in various arrangements (e.g., aisles or stacks) around various types of data rooms 305 to determine or identify airflow (e.g., 505 or 510) around the room based on hotspots 520. The one or more processors 710 can be configured to determine, using the color and the location input into the one or more ML models 640, that a computing device of the plurality of computing devices generates the heat that impacts the flow of air (e.g., 505, 510) toward the portion of the layer 115 on the curtain 405.

The one or more processors 710 can be configured to take corrective action responsive to the determination of the temperature based on the hotspot 520 on a thermographic layer 115. For example, the one or more processor 710 can load balance the requests 655 incoming to the computing devices 315 across the plurality of computing devices 315 responsive to the determination of the hotspot 520. The one or more ML models 640 can identify the locations of the specific computing devices 315 in the data room 305, and based on the location of the hotspot 520 with respect to the identified location of one or more markers 525, determine to adjust the number or flow rate of requests 655 to the identified computing device 315 to load balance the computing device 315 and adjust the temperature or the airflow (e.g., 505, 510). The one or more processors 710 can be configured to adjust the operation or positioning of an airflow feature 320 to correct the airflow and alleviate or impact the airflow, thereby redistributing the heat and reducing the hotspot 520.

The one or more processors 710 can be configured to configured to determine that a second computing device 315 of the plurality of computing devices 315 processes more network traffic than the computing device 315. The one or more processors 710 can be configured to determine to provide one or more new requests 665 to the second computing device 315 responsive to the determination that the computing device 315 generates the heat that impacts the flow of air (e.g., 505, 510).

The one or more processors 710 can be configured to identify a marker 525 on the curtain The one or more processors 710 can be configured to detect, responsive to a location of the marker 525 on the curtain 405, a location of the portion of the layer 115. The one or more processors 710 can be configured to identify the one or more layers 115 of thermographic material 120. The one or more processors 710 can be configured to identify the layer of the one or more layers (e.g., 115) using the one or more video frames 615 input into the one or more ML models 640. The one or more processors 710 can be configured to detect that the color of the portion of the layer 115 has changed using the one or more ML models 640 and in response to this detection, identify the temperature at the hotspot 520.

The one or more processors 710 can be configured to detect, using the one or more ML models 640, that the color of the portion of the layer 115 has changed. The one or more processors 710 can be configured to determine a temperature at the location of the portion of the layer 115 responsive to the detected color of the portion of the layer 115. The one or more processors 710 can be configured to determine, using the one or more ML models the flow of air impacted by the heat. The one or more processors 710 can be configured to adjust, responsive to the determination, an airflow feature to change the flow of air (e.g., 505, 510).

The one or more processors 710 can be configured to determine the flow of air (e.g., 505, 510) impacted by the heat using the one or more ML models 640. The one or more processors 710 can be configured to generate settings for features 320 to control the flow of air (e.g., 505, 510) based at least on the color and the location input into the one or more ML models 640.

In an aspect, the technical solutions can be directed to a non-transitory computer readable medium. The non-transitory computer readable medium can store program instructions to cause at least one processor of a device to perform any actions of the technical solutions (e.g., DPS 625 or its components or features) when executed by the at least one processor. The instructions, when executed by the at least one processor, can configure the at least one processor 710 to identify, using one or more video frames 615 captured by a camera 605, one or more layers of thermographic material 115 applied on one or more portions of a transparent material 110 of a curtain 405. The curtain 405 can be disposed adjacent to a plurality of cabinets 310 housing a plurality of computing devices 315 configured to process requests and generate heat. The instructions, when executed by the at least one processor 710, can configure the at least one processor 710 to detect that a color of a portion of a layer 115 of the one or more layers of thermographic material (e.g., 115) is indicative of a temperature of a flow of air (e.g., 505, 510) impacted by the heat.

The instructions, when executed by the at least one processor 710, can configure the at least one processor 710 to determine, using the color and the location input into one or more machine learning (ML) models 640 trained on the plurality of colors of a plurality of thermographic materials 120 on a plurality of curtains 405 adjacent to cabinets 310 housing computing devices 315, that a computing device 315 of the plurality of computing devices generates the heat that impacts the flow of air (e.g., 505, 510) toward the portion of the layer 115. The instructions, when executed by the at least one processor, can configure the at least one processor 710 to load balance the requests 665 across the plurality of computing devices 315 responsive to the determination by the one or more ML models 640.

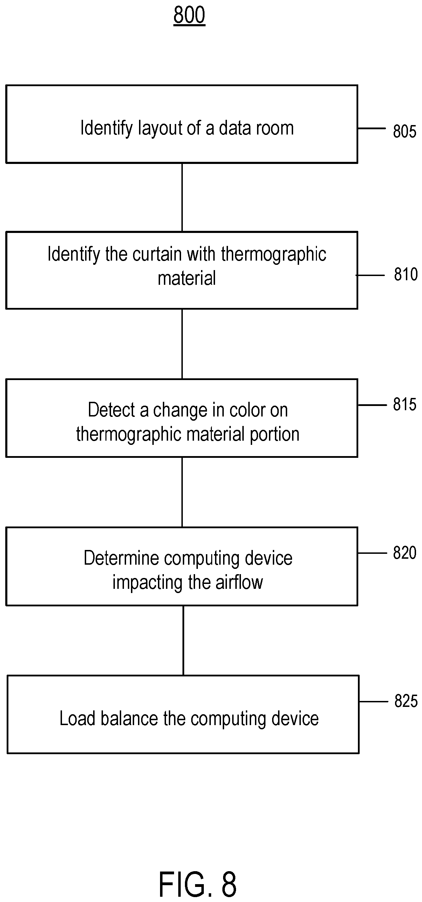

FIG. 8 shows another example process flow of a method 800 for ML-based thermal management of a data room using curtains with thermographic layers. Method 800 can include, for example, an example process flow for implementing load balancing across computing devices using ML-based thermal management of a data room based on color changes on thermographic layers of containment curtains. Method 800 can be implemented using the system tools, devices and components discussed herein (e.g., system examples 100-700) discussed, for example in connection with FIGS. 1-7. Method 800 can include acts 805-825. At act 805, a layout of a data room can be identified. At act 810, a curtain with a thermographic layer can be identified. At act 815, a change in color on thermographic material portion can be detected. At act 820, a computing device impacting the airflow can be determined. At act 825, take adjustment action to change temperature around the identified computing device.

At act 805, a layout of a data room can be identified. The method can include identifying, by one or more processors coupled with memory, a plurality of cabinets. The method can include identifying, by the one or more processors, a plurality of computing devices housed within each cabinet of the plurality of cabinets to generate heat. The method can include detecting, by the one or more processors, one or more portions of transparent material to form a curtain adjacent to the plurality of cabinets to control a flow of air impacted by the heat. The method can include detecting, by the one or more processors, one or more layers of thermographic material applied on the one or more portions of transparent material to change a color of the one or more layers of the thermographic material responsive to a change in temperature caused by the flow of air.

At act 810, a curtain with a thermographic layer can be identified. The method can include identifying, by one or more processors coupled with memory, using one or more video frames captured by a camera, one or more layers of thermographic material applied on one or more portions of a transparent material of a curtain. The curtain disposed adjacent to a plurality of cabinets housing a plurality of computing devices configured to process requests and generate heat.

At act 815, a change in color on thermographic material portion can be detected. The method can include detecting, by the one or more processors, that a color of a portion of a layer of the one or more layers of thermographic material is indicative of a temperature of a flow of air impacted by the heat. For example, one or more ML models can determine, based on image frames input into the one or more ML models, that the color of the portion of the layer on a curtain has changed and that it indicates a particular temperature or a temperature range.

At act 820, a computing device impacting the airflow can be determined. The method can include determining, by the one or more processors, using the color and the location input into one or more machine learning (ML) models trained on the plurality of colors of a plurality of thermographic materials on a plurality of curtains adjacent to cabinets housing computing devices, that a computing device of the plurality of computing devices generates the heat that impacts the flow of air toward the portion of the layer. For example, the one or more ML models can determine, based on one or more image frames input into the one or more ML models, a location of a marker and a location of a hotspot (e.g., color change on the thermographic material layer). The one or more ML models can determine the location of the hotspot, based on the color change. The one or more ML models can determine the temperature or the temperature range of the airflow or air current adjacent to, or impacting, the hotspot.

At act 825, an adjustment action is performed to change temperature around the identified computing device. The adjustment action can include taking any corrective action to address the hotspot, operation of one or more computing devices, or airflow features, responsive to the determination at 820. The method can include load balancing, by the one or more processors, the requests across the plurality of computing devices responsive to the determination. The method can include adjusting the position or the operation of the airflow feature, responsive to the determination, in order to impact or change the flow of air. The method can include identifying a faulty computing device, a faulty airflow feature or an error in the system. The method can include identifying an error with an air conditioning unit or a fan. Alternatively, or in addition, the adjustment action can include adjusting an airflow that causes cooler (or higher) temperature air to flow in the vicinity of the identified computing device. The airflow can be adjusted by changing the direction of one or more vents, airflow controllers, etc. Alternatively, the airflow can be adjusted by changing the temperature of the air being channeled to the data room, and in particularly in the vicinity of the identified computing device. Several other such actions can be taken as part of the adjustment action.

The foregoing examples have been provided merely for the purpose of explanation and are in no way to be construed as limiting of the present disclosure. While aspects of the present disclosure have been described with reference to an exemplary embodiment, it is understood that the words which have been used herein are words of description and illustration, rather than words of limitation. Changes may be made, within the purview of the appended claims, as presently stated and as amended, without departing from the scope and spirit of the present disclosure in its aspects. Although aspects of the present disclosure have been described herein with reference to particular means, materials and embodiments, the present disclosure is not intended to be limited to the particulars disclosed herein; rather, the present disclosure extends to all functionally equivalent structures, methods and uses, such as are within the scope of the appended claims.

The systems described above can provide multiple ones of any or each of those components and these components can be provided on either a standalone system or on multiple instantiations in a distributed system. Example and non-limiting module implementation elements can include components, such as detectors or sensors providing or using any value determined herein or sensors providing any value that is a precursor to a value determined herein. Implementation elements can also include a datalink or network hardware including communication chips, oscillating crystals, communication links, cables, twisted pair wiring, coaxial wiring, shielded wiring, transmitters, receivers, or transceivers, logic circuits, hard-wired logic circuits, reconfigurable logic circuits in a particular non-transient state configured according to the module specification, any actuator including at least an electrical, hydraulic, or pneumatic actuator, a solenoid, an op-amp, analog control elements (springs, filters, integrators, adders, dividers, gain elements), or digital control elements.

While operations are depicted in the drawings in a particular order, such operations are not required to be performed in the particular order shown or in sequential order, and all illustrated operations are not required to be performed. Actions described herein can be performed in a different order and functions from one illustrated block can be called by other functions in other blocks. Also, although many of the examples presented herein involve specific combinations of method acts or system elements, those acts, and those elements may be combined in other ways to accomplish the same objectives. Acts, elements and features discussed in connection with one implementation are not intended to be excluded from a similar role in other implementations or implementations.

The phraseology and terminology used herein is for the purpose of description and should not be regarded as limiting. The use of "including" "comprising" "having" "containing" "involving" "characterized by" "characterized in that" and variations thereof herein, is meant to encompass the items listed thereafter, equivalents thereof, and additional items, as well as alternate implementations consisting of the items listed thereafter exclusively. In one implementation, the systems and methods described herein consist of one, each combination of more than one, or all of the described elements, acts, or components.

Any references to implementations or elements or acts of the systems and methods herein referred to in the singular may also embrace implementations including a plurality of these elements, and any references in plural to any implementation or element or act herein may also embrace implementations including only a single element. References in the singular or plural form are not intended to limit the presently disclosed systems or methods, their components, acts, or elements to single or plural configurations. References to any act or element being based on any information, act or element may include implementations where the act or element is based at least in part on any information, act, or element.

Any implementation disclosed herein may be combined with any other implementation or embodiment, and references to "an implementation," "some implementations," "one implementation" or the like are not necessarily mutually exclusive and are intended to indicate that a particular feature, structure, or characteristic described in connection with the implementation may be included in at least one implementation or embodiment. Such terms as used herein are not necessarily all referring to the same implementation. Any implementation may be combined with any other implementation, inclusively or exclusively, in any manner consistent with the aspects and implementations disclosed herein.

References to "or" may be construed as inclusive so that any terms described using "or" may indicate any of a single, more than one, and all of the described terms. References to at least one of a conjunctive list of terms may be construed as an inclusive OR to indicate any of a single, more than one, and all of the described terms. For example, a reference to "at least one of 'A' and 'B'" can include only 'A', only 'B', as well as both 'A' and 'B'. Such references used in conjunction with "comprising" or other open terminology can include additional items.

Where technical features in the drawings, detailed description or any claim are followed by reference signs, the reference signs have been included to increase the intelligibility of the drawings, detailed description, and claims. Accordingly, neither the reference signs nor their absence have any limiting effect on the scope of any claim elements. Modifications of described elements and acts such as variations in sizes, dimensions, structures, shapes and proportions of the various elements, values of parameters, mounting arrangements, use of materials, colors, orientations can occur without materially departing from the teachings and advantages of the subject matter disclosed herein. For example, elements shown as integrally formed can be constructed of multiple parts or elements, the position of elements can be reversed or otherwise varied, and the nature or number of discrete elements or positions can be altered or varied. Other substitutions, modifications, changes and omissions can also be made in the design, operating conditions and arrangement of the disclosed elements and operations without departing from the scope of the present disclosure. Coupled elements can be electrically, mechanically, or physically coupled with one another directly or with intervening elements. Scope of the systems and methods described herein is thus indicated by the appended claims, rather than the foregoing description, and changes that come within the meaning and range of equivalency of the claims are embraced therein.

The disclosure comprises the following clauses:
1. A system, comprising:
   one or more portions of material to form a curtain adjacent to a plurality of cabinets that house a plurality of computing devices that generate heat, the curtain to control a flow of air impacted by the heat; and
   one or more layers of thermographic material applied on the one or more portions of material to change a color of the one or more layers of the thermographic material responsive to a change in temperature caused by the flow of air.
2. The system of clause 1, wherein the one or more portions of material includes a plurality of strips of a polymer material, the polymer material at least partially transparent to light in a visible spectral range.
3. The system of any of the clauses 1-2, wherein the plurality of strips includes at least two strips of the plurality of strips suspended vertically and at least partly overlapping side by side with each other to form the curtain.
4. The system of any of the clauses 1-3, wherein the one or more layers of thermographic material includes a layer of a plurality of thermographic materials, wherein each thermographic material of the plurality of thermographic materials corresponds to a separate portion of the layer.
5. The system of any of the clauses 1-4, wherein the one or more layers of thermographic material includes a plurality of layers of the thermographic materials.
6. The system of any of the clauses 1-5, wherein each layer of the plurality of layers of the thermographic materials includes a thermographic material configured to change color responsive to experiencing temperature within a predetermined temperature range.
7. The system of any of the clauses 1-6, wherein the one or more layers of thermographic material includes a plurality of portions of a layer covering a plurality of portions of a surface of the material, each of the portions of the layer including a different thermographic material of a plurality of thermographic materials.
8. The system of any of the clauses 1-7, comprising:
   a layer of the one or more layers of the thermographic material includes a first portion of the layer covering a first portion of the material and including a first thermographic material configured to change color responsive to a change in temperature over a first temperature range and a second portion of the layer covering a second portion of the material and including a second thermographic material configured to change color responsive to a change in temperature over a second temperature range different than the first temperature range.
9. The system of any of the clauses 1-8, comprising:
   an aisle formed by the plurality of cabinets; and
   a bracket to suspend the curtain adjacent to the aisle to control the flow of air within the aisle impacted by the heat generated by the plurality of cabinets.
10. The system of clause 9, wherein each computing device of the plurality of computing devices includes one or more integrated circuits to process data responsive to requests and generate the heat to impact the flow of air in the aisle responsive to the processing of data.
11. The system of any of the clauses 9-10, comprising one or more features of the plurality of cabinets to control the flow of air within the aisle.
12. The system of any of the clauses 9-11, wherein the one or more features are adjustable responsive to a change in the color of the one or more layers of the thermographic material.
13. The system of any of the clauses 9-12, wherein the plurality of cabinets includes a first plurality of cabinets on a first side of the aisle and a second plurality of cabinets on a second side of the aisle, the aisle parallel to a second aisle formed by the second plurality of cabinets and a third plurality of cabinets comprising one or more computing devices of the plurality of computing devices.
14. The system of any of the clauses 9-13, wherein the curtain forms a barrier surrounding the aisle to preclude the flow of air along at least a length of the aisle and a width of the aisle.
15. A system, comprising:
   one or more processors coupled with memory and configured to:
   identify, using one or more image frames captured by a camera, one or more layers of thermographic material applied on one or more portions of a material of a curtain, the curtain disposed adjacent to a plurality of cabinets housing a plurality of computing devices configured to process requests and generate heat;
   detect that a color of a portion of a layer of the one or more layers of thermographic material is indicative of a temperature of a flow of air impacted by the heat;
   determine, using the color and the location input into one or more machine learning (ML) models trained on the plurality of colors of a plurality of thermographic materials on a plurality of curtains adjacent to cabinets housing computing devices, that a computing device of the plurality of computing devices generates the heat that impacts the flow of air toward the portion of the layer; and
   load balance the requests across the plurality of computing devices responsive to the determination.
16. The system of clause 15, comprising the one or more processors configured to:
   determine that a second computing device of the plurality of computing devices processes more network traffic than the computing device; and
   determine to provide one or more new requests to the second computing device responsive to the determination that the computing device generates the heat that impacts the flow of air.
17. The system of any of the clauses 15-16, comprising the one or more processors configured to:
   identify a marker on the curtain; and
   detect, responsive to a location of the marker on the curtain, a location of the portion of the layer.
18. The system of any of the clauses 15-17, comprising the one or more processors configured to:
   identify the one or more layers of thermographic material;
   identify the layer of the one or more layers using the one or more video frames input into the one or more ML models.
19. The system of any of the clauses 15-18, comprising the one or more processors configured to:
   detect, using the one or more ML models, that the color of the portion of the layer has changed; and
   responsive to the detected color of the portion of the layer determine a temperature at a location of the portion.
20. The system of any of the clauses 15-19, comprising the one or more processors configured to:
   determine, using the one or more ML models the flow of air impacted by the heat; and
   adjust, responsive to the determination, an airflow feature to change the flow of air.
21. The system of any of the clauses 15-20, comprising the one or more processors configured to generate settings for features to control the flow of air based at least on the color and the location input into the one or more ML models.
22. A non-transitory computer readable medium storing program instructions to cause at least one processor of a device to:
   identify, using one or more video frames captured by a camera, one or more layers of thermographic material applied on one or more portions of a material of a curtain, the curtain disposed adjacent to a plurality of cabinets housing a plurality of computing devices configured to process requests and generate heat;
   detect that a color of a portion of a layer of the one or more layers of thermographic material is indicative of a temperature of a flow of air impacted by the heat;
   determine, using the color and the location input into one or more machine learning (ML) models trained on the plurality of colors of a plurality of thermographic materials on a plurality of curtains adjacent to cabinets housing computing devices, that a computing device of the plurality of computing devices generates the heat that impacts the flow of air toward the portion of the layer; and
   load balance the requests across the plurality of computing devices responsive to the determination.
23. A method, comprising:
   identifying, by one or more processors coupled with memory, using one or more video frames captured by a camera, one or more layers of thermographic material applied on one or more portions of a material of a curtain, the curtain disposed adjacent to a plurality of cabinets housing a plurality of computing devices configured to process requests and generate heat;
   detecting, by the one or more processors, that a color of a portion of a layer of the one or more layers of thermographic material is indicative of a temperature of a flow of air impacted by the heat;
   determining, by the one or more processors, using the color and the location input into one or more machine learning (ML) models trained on the plurality of colors of a plurality of thermographic materials on a plurality of curtains adjacent to cabinets housing computing devices, that a computing device of the plurality of computing devices generates the heat that impacts the flow of air toward the portion of the layer; and
   load balancing, by the one or more processors, the requests across the plurality of computing devices responsive to the determination.
24. A method, comprising:
   identifying, by one or more processors coupled with memory, a plurality of cabinets;
   identifying, by the one or more processors, a plurality of computing devices housed within each cabinet of the plurality of cabinets to generate heat;
   detecting, by the one or more processors, one or more portions of material to form a curtain adjacent to the plurality of cabinets to control a flow of air impacted by the heat; and
   detecting, by the one or more processors, one or more layers of thermographic material applied on the one or more portions of material to change a color of the one or more layers of the thermographic material responsive to a change in temperature caused by the flow of air.
25. An apparatus, comprising:
   a curtain that extends along at least a portion of an array of cabinets that house a plurality of computing devices in a data center, the curtain comprising:
   an opening to receive heat dissipated from the plurality of computing devices at the at least the portion of the array; and
   a thermographic material configured to change color to indicate an amount of the heat dissipated by the plurality of computing devices located at the at least the portion of the array.
26. The apparatus of clause 25, wherein the curtain comprises a plurality of portions of strips, each strip of the plurality of strips comprising one or more portions of the strip having one or more layers of the thermographic material.
27. The apparatus of any of the clauses 25-26, wherein the opening is formed by the curtain arranged to surround an area adjacent to the array of cabinets to control a flow of air dissipating heat from the computing devices to the thermographic material.
28. The apparatus of any of the clauses 25-27, wherein the thermographic material is located on at least a portion of the curtain of a plurality of portions of the curtain that include the thermographic material.
29. The apparatus of any of the clause 28, wherein the portion of the curtain is located relative to a mark on a second portion of the curtain configured to indicate to a data processing system, utilizing a camera to capture an image of the portion of the curtain, a direction of a flow of air dissipating heat from the portion of the array of cabinets.
30. The apparatus of clause 29, wherein the data processing system is configured to generate an instruction to reduce the amount of heat.

The disclosure also comprises the following items:
1. A system, comprising:
   one or more processors, coupled with memory, to:
   identify, using one or more image frames captured by a camera, one or more layers of thermographic material applied on one or more portions of a material of a curtain, the curtain disposed adjacent to a plurality of cabinets housing a plurality of computing devices configured to process requests and generate heat;
   detect that a color of a portion of a layer of the one or more layers of thermographic material is indicative of a temperature of a flow of air impacted by the heat;
   determine, using the color and a location of the portion of the layer input into one or more machine learning (ML) models trained on the plurality of colors of a plurality of thermographic materials on a plurality of curtains adjacent to cabinets housing computing devices, that a computing device of the plurality of computing devices generates the heat that impacts the flow of air toward the portion of the layer; and
   load balance the requests across the plurality of computing devices responsive to the determination.
2. The system of item 1, wherein the one or more processors:
   determine that a second computing device of the plurality of computing devices processes more network traffic than the computing device; and
   determine to provide one or more new requests to the second computing device responsive to the determination that the computing device generates the heat that impacts the flow of air.
3. The system of item 1 or 2, wherein the one or more processors:
   identify a marker on the curtain; and
   detect, responsive to a location of the marker on the curtain, a location of the portion of the layer.
4. The system of any preceding item, wherein the one or more processors:
   identify the one or more layers of thermographic material; and
   identify the layer of the one or more layers using the one or more image frames input into the one or more ML models.
5. The system of any preceding item, wherein the one or more processors:
   detect, using the one or more ML models, that the color of the portion of the layer has changed; and
   responsive to the detected color of the portion of the layer determine a temperature at a location of the portion.
6. The system of any preceding item, wherein the one or more processors:
   determine, using the one or more ML models the flow of air impacted by the heat; and
   adjust, responsive to the determination, an airflow feature to change the flow of air.
7. The system of any preceding item, wherein the one or more processors:
   generate settings for features to control the flow of air based at least on the color and the location input into the one or more ML models.
8. The system of any preceding item, wherein the curtain disposed adjacent to the plurality of cabinets is configured to control the flow of air impacted by the heat from the plurality of cabinets and the one or more layers of thermographic material is configured to change the color of the portion of the layer responsive to a change in temperature caused by the flow of air.
9. The system of any preceding item, wherein the one or more portions of material includes a plurality of strips of a polymer material, the polymer material at least partially transparent to light in a visible spectral range.
10. The system of item 9, wherein the plurality of strips includes at least two strips of the plurality of strips suspended vertically and at least partly overlapping side by side with each other to form the curtain.
11. The system of any preceding item, wherein the one or more layers of thermographic material includes a plurality of layers of the thermographic materials, each layer of the plurality of layers including a thermographic material configured to change color responsive to experiencing temperature within a predetermined temperature range.
12. The system of any preceding item, wherein the one or more layers of thermographic material includes a plurality of portions of a layer covering a plurality of portions of a surface of a material of the curtain, each of the portions of the layer including a different thermographic material of a plurality of thermographic materials.
13. The system of any preceding item, wherein the layer of the one or more layers of the thermographic material includes a first portion of the layer covering a first portion of the material and including a first thermographic material configured to change color responsive to a change in temperature over a first temperature range and a second portion of the layer covering a second portion of the material and including a second thermographic material configured to change color responsive to a change in temperature over a second temperature range different than the first temperature range.
14. A method, comprising:
   identifying, by one or more processors coupled with memory, using one or more image frames captured by a camera, one or more layers of thermographic material applied on one or more portions of a material of a curtain, the curtain disposed adjacent to a plurality of cabinets housing a plurality of computing devices configured to process requests and generate heat;
   detecting, by the one or more processors, that a color of a portion of a layer of the one or more layers of thermographic material is indicative of a temperature of a flow of air impacted by the heat;
   determining, by the one or more processors, using the color and a location of the portion of the layer input into one or more machine learning (ML) models trained on the plurality of colors of a plurality of thermographic materials on a plurality of curtains adjacent to cabinets housing computing devices, that a computing device of the plurality of computing devices generates the heat that impacts the flow of air toward the portion of the layer; and
   load balancing, by the one or more processors, the requests across the plurality of computing devices responsive to the determination.
15. The method of item 14 further comprising carrying out the steps as carried out by the processor of any of items 2 to 7.
16. A computer readable medium storing program instructions to cause at least one processor of a device to carry out the method of item 14 or 15.

## Claims

1. A system, comprising:
one or more processors, coupled with memory, to:
identify, using one or more image frames captured by a camera, one or more layers of thermographic material applied on one or more portions of a material of a curtain, the curtain disposed adjacent to a plurality of cabinets housing a plurality of computing devices configured to process requests and generate heat;
detect that a color of a portion of a layer of the one or more layers of thermographic material is indicative of a temperature of a flow of air impacted by the heat;
determine, using the color and a location of the portion of the layer input into one or more machine learning (ML) models trained on the plurality of colors of a plurality of thermographic materials on a plurality of curtains adjacent to cabinets housing computing devices, that a computing device of the plurality of computing devices generates the heat that impacts the flow of air toward the portion of the layer; and
load balance the requests across the plurality of computing devices responsive to the determination.

2. The system of claim 1, wherein the one or more processors:
determine that a second computing device of the plurality of computing devices processes more network traffic than the computing device; and
determine to provide one or more new requests to the second computing device responsive to the determination that the computing device generates the heat that impacts the flow of air.

3. The system of claim 1 or 2, wherein the one or more processors:
identify a marker on the curtain; and
detect, responsive to a location of the marker on the curtain, a location of the portion of the layer.

4. The system of any preceding claim, wherein the one or more processors:
identify the one or more layers of thermographic material; and
identify the layer of the one or more layers using the one or more image frames input into the one or more ML models.

5. The system of any preceding claim, wherein the one or more processors:
detect, using the one or more ML models, that the color of the portion of the layer has changed; and
responsive to the detected color of the portion of the layer determine a temperature at a location of the portion.

6. The system of any preceding claim, wherein the one or more processors:
determine, using the one or more ML models the flow of air impacted by the heat; and
adjust, responsive to the determination, an airflow feature to change the flow of air.

7. The system of any preceding claim, wherein the one or more processors:
generate settings for features to control the flow of air based at least on the color and the location input into the one or more ML models.

8. The system of any preceding claim, wherein the curtain disposed adjacent to the plurality of cabinets is configured to control the flow of air impacted by the heat from the plurality of cabinets and the one or more layers of thermographic material is configured to change the color of the portion of the layer responsive to a change in temperature caused by the flow of air.

9. The system of any preceding claim, wherein the one or more portions of material includes a plurality of strips of a polymer material, the polymer material at least partially transparent to light in a visible spectral range.

10. The system of claim 9, wherein the plurality of strips includes at least two strips of the plurality of strips suspended vertically and at least partly overlapping side by side with each other to form the curtain.

11. The system of any preceding claim, wherein the one or more layers of thermographic material includes a plurality of layers of the thermographic materials, each layer of the plurality of layers including a thermographic material configured to change color responsive to experiencing temperature within a predetermined temperature range.

12. The system of any preceding claim, wherein the one or more layers of thermographic material includes a plurality of portions of a layer covering a plurality of portions of a surface of a material of the curtain, each of the portions of the layer including a different thermographic material of a plurality of thermographic materials.

13. The system of any preceding claim, wherein the layer of the one or more layers of the thermographic material includes a first portion of the layer covering a first portion of the material and including a first thermographic material configured to change color responsive to a change in temperature over a first temperature range and a second portion of the layer covering a second portion of the material and including a second thermographic material configured to change color responsive to a change in temperature over a second temperature range different than the first temperature range.

14. A method, comprising:
identifying, by one or more processors coupled with memory, using one or more image frames captured by a camera, one or more layers of thermographic material applied on one or more portions of a material of a curtain, the curtain disposed adjacent to a plurality of cabinets housing a plurality of computing devices configured to process requests and generate heat;
detecting, by the one or more processors, that a color of a portion of a layer of the one or more layers of thermographic material is indicative of a temperature of a flow of air impacted by the heat;
determining, by the one or more processors, using the color and a location of the portion of the layer input into one or more machine learning (ML) models trained on the plurality of colors of a plurality of thermographic materials on a plurality of curtains adjacent to cabinets housing computing devices, that a computing device of the plurality of computing devices generates the heat that impacts the flow of air toward the portion of the layer; and
load balancing, by the one or more processors, the requests across the plurality of computing devices responsive to the determination.

15. A computer readable medium storing program instructions to cause at least one processor of a device to:
identify, using one or more image frames captured by a camera, one or more layers of thermographic material applied on one or more portions of a material of a curtain, the curtain disposed adjacent to a plurality of cabinets housing a plurality of computing devices configured to process requests and generate heat;
detect that a color of a portion of a layer of the one or more layers of thermographic material is indicative of a temperature of a flow of air impacted by the heat;
determine, using the color and a location of the portion of the layer input into one or more machine learning (ML) models trained on the plurality of colors of a plurality of thermographic materials on a plurality of curtains adjacent to cabinets housing computing devices, that a computing device of the plurality of computing devices generates the heat that impacts the flow of air toward the portion of the layer; and
load balance the requests across the plurality of computing devices responsive to the determination.
